# EUROPEAN PATENT SPECIFICATION

(11) **EP 0 409 174 B1**
(45) Date of publication and mention of the grant of the patent: **09.06.2004**
(21) Application number: 90113691.1
(22) Date of filing: 17.07.1990
(51) Int. Cl.: H01L 27/148

(54) **Structure of solid-state image sensing devices**
Struktur für Festkörperbildaufnahmeanordnungen
Structure des dispositifs capteur d'images à l'état solide

(30) Priority: 20.07.1989 JP 18855889; 17.07.1989 JP 18504589
(43) Date of publication of application: 23.01.1991
(73) Proprietor: SONY CORPORATION, Tokyo (JP)
(72) Inventor: Yonemoto, Kazuya, C/o Sony Corporation, Tokyo (JP); Iizuka, Tetsuya, C/o Sony Corporation, Tokyo (JP); Wada, kazushi, C/o Sony Corporation, Tokyo (JP); Harada, Koichi, C/o Sony Corporation, Tokyo (JP); Yamamura, Michio, C/o Sony Corporation, Tokyo (JP)
(74) Representative: Schmidt-Evers, Jürgen, Dipl.-Ing.

(56) References cited:
- EP-A- 0 127 223
- DE-A- 3 436 632
- PATENT ABSTRACTS OF JAPAN, vol. 9, no. 159, (E-326)[1882], 4th July 1985; & JP-A-60 38 869 (NIPPON DENKI K.K.) 28-02-1985
- IDEM
- PATENT ABSTRACTS OF JAPAN, vol. 12, no. 369 (E-665)[3216], 4th October 1988; & JP-A-63 120 463 (MATSUSHITA ELECTRIC IND. CO., LTD) 24-05-1988

## Description

The present invention relates to a structure of a solid-state frame interline type (FIT) imager or image sensing device in which signal charges generated by a plurality of photo receiving elements arranged in a matrix form are transferred in a vertical direction by means of a plurality of vertical registers and the signal charges transferred by means of the plurality of vertical registers are partially transferred by means of a plurality of horizontal registers.

It becomes necessary to provide a high resolution for solid-state image sensing devices commonly used as photographing means in video cameras in order to meeet requirements for highly resolved video cameras. Specifically, the number of pixels (constituted by the photo receiving elements) arranged in a matrix form must be increased. Although the number of pixels in the solid-state image sensing device of a commercially available video camera are about 300 thousands through 400 thousands, about 2,000 thousands of pixels are required since the resolution is five times higher than that in the comercially available video camera in the case of the video camera applicable to an HDTV (High Definition Television).

In addition, since an increase in size of a chip in proportional to the increase in the number of pixels is not allowed, the number of pixels must remarkably be increased with no increase in the chip size.

Since a limit of the number of pixels aligned in a horizontal direction is generally determined acording to a unit length of one bit of a horizontal register with the chip size of the solid-state image sensing device constant, this horizontal register provides a factor for restricting the high resolution of the image sensing device.

A Japanese Patent Application Second Publication (Examined) No. Heisei 1- 13676 published on March 7, 1989 exemplifies the structure of the solid-state image sensing device in which a plurality of horizontal registers are arranged in parallel to one another and signals charges generated by means of the photo receiving elements and transferred in the vertical direction by means of the vertical registers are shared and distributed into a plurality of horizontal registers so that an improvement in integrations of the pixels in the horizontal direction can be achieved.

A result of study on the solid-state image sensing devices in which the horizontal registers are installed is published in a paper of Television Society Vol. 41, No. 11 (published in 1987) titled " Super High Resolution CCD Image Sensor " on pages 74 to 80.

One previously proposed solid-state image sensing device includes: a photo receiving portion in which photo receiving elements are arranged in the matrix form; a storage portion located below the photo receiving portion; a gate region located at a side of storage portion opposite to the photo receiving portion, the gate region transferring signal charges to a first horizontal register at the same time when receiving a gate voltage.

The first horizontal register is arranged at a side of the gate region opposite to the storage portion. A control gate is arranged at a side of the first horizontal register opposite to the control gate. A second horizontal register is arranged at.a side of the control gate opposite to the first horizontal register. A multiplexor is provided for multiplexing the signal charges derived from the first and second horizontal registers.

The control gate transfers signal charges transferred from any other vertical registers which does not correspond to respective channel stoppers provided at every other interval along the control gate to the second horizontal register.

In addition, the control gate is formed by a first layer of a polycrystalline silicon layer. The polycrystalline silicon layer is located above an insulating film formed on a main surface of a semiconductor substrate.

It is noted that an interlayer insulating film encloses the control gate and transfer electrodes are formed so as to intersect the control gate via the interlayer insulating film. The transfer electrodes serve to drive the horizontal registers. The transfer electrodes for the horizontal registers are arranged so that second and third layers of polycrystalline silicon layers are alternatingly arranged in the horizontal direction. One of the transfer electrodes constituted by one of the polycrystalline silicon layers receives a pulse Ø₁ and the other transfer electrode constituted by the other polycrystalline silicon layer receives a pulse Ø₂.

Since the previously proposed solid-state image sensing device applicable to an HDVS is provided with the control gate having a relatively long length of, e.g., about 15 mm, an application of a gate voltage Ø_{HP} to the control gate is carried out from both ends of the control gate in order to reduce a time of propagation delay of the control signal transmitted thereto as short as possible.

However, since a specific resistance (resistivity) of the polycrystalline silicon layer is never low and therefore an equivalent circuit of a transmission path of the gate voltage is constituted by a plurality of R-C circuits, a waveform of the gate voltage Ø_{HP} is distorted at the control gate and/or its amplitude becomes reduced. In this way, when a time constant of the transmission path becomes large, the propagation delay occurs and gives an ill effect on operating characteristics of the control gate.

Especially, since the transfer of the signal charges toward the horizontal registers by means of the control gate must be carried out within a very short horizontal blanking interval in a television system of HDVS (High Definition Video System), such a propagation delay as described above cannot be neglected any more.

From JP-A-63 120 463 is known a solid-state FIT imager having multi-layer electrodes formed of laminated poly-Si and silicide to reduce a sheet resistance of a vertical transfer electrode.

### SUMMARY OF THE INVENTION

It is an object of the present invention to provide a structure of a solid-state image sensing device in which at least one of drive pulse transmission paths of a control gate for controlling transfer of signal charges transferred from vertical registers toward horizontal registers in synchronization with first drive pulses and of transfer electrodes provided for driving vertical registers to transfer signal charges generated in a plurality of photo receiving elements can achieve reduced drive pulse signal propagation delays and reduced signal distortions.

This object is achieved by a solid-state frame interline type (FIT) imager according to the enclosed independent claim 1. Advantageous features of the present invention are defined in the corresponding subclaims.

### BRIEF DESCRIPTION OF THE DRAWINGS:

Fig. 1 is a schematic elevational view of an internal structure of an image sensing device in a first additional development of a device according to the present invention.
Fig. 2 is a cross sectional view cut away along the line of II - II of Fig. 1.
Fig. 3 (A) is a circuit wiring diagram of a control gate in the first additional development shown in Figs. 1 and 2.
Fig. 3 (B) is an equivalent circuit diagram of Fig. 3 (A).
Fig. 4 is a schematic elevational view of an internal circuit of the structure of the image sensing device in a second additional development of a device according to the present invention.
Fig. 5 is a cross sectional view cut away along the line of V - V of Fig. 4.
Fig. 6 is a chematic elevational view of the structure of the image sensing device in a preferred embodiment according to the present invention.

### DETAILED DESCRIPTION OF THE PREFERRED EMBODIMENT:

Reference will hereinafter be made to the drawings in order to facilitate a better understanding of the present invention.

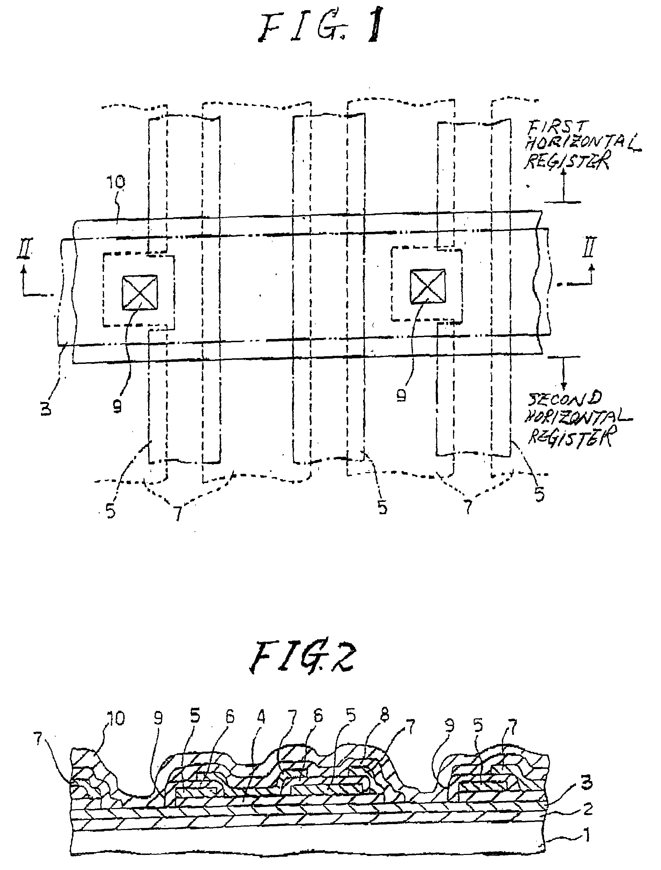

Figs. 1 through 3(B) show a first preferred additional development to be used with a solid-state frame interline type imager according to the present invention which will be described below.

In the drawings of Figs. 1 and 2, a semiconductor substrate 1 is located below an insulating film constituted by SiO₂ (silicon dioxide). A first polycrystalline silicon layer 3 is formed on the surface of the SiO₂ insulating layer. A plurality of interlayer insulating layers 4 are formed on the control gate 3. A plurality of transfer electrodes 5 for driving horizontal registers constituted by second polycrystalline silicon layers are formed on the respective interlayer insulating layers 4. A plurality of interlayer insulating layers 6 are formed so as to enclose the respective transfer electrodes 5. A plurality of other transfer electrodes 7 for driving the horizontal registers are formed on the interlayer insulating layers 6.

In addition, as shown in Fig. 2, numeral 8 denotes a plurality of interlayer insulating layers, numerals 9, 9, -- denotes contact regions through which the control gate 3 is partially exposed, numeral 10 denotes a metal wiring layer, constituted by, e.g., aluminium, connecting the control gate 3 to the contact regions 9, 9.

In the first preferred additional development, the control gate 3 for controlling signal charge transfer between two horizontal registers is constituted by the first polycrystalline silicon layer. The transfer electrodes 5, 7, 5, 7, -- controlling the two horizontal registers are formed by the second and third polycrystalline silicon layers. Then, the metal wiring layer 10 which serves as a shunt wire to intend a lower specific resistance for the control gate 3 is placed on an upper layer than the third polycrystalline silicon layers 7, 7, 7, ---. The contact regions 9, 9, --- serve to contact between the metal wiring layer 10 and control gate 3.

The second and third multicrystalline silicon layers 5, 5, 7, 7, --- constituted by the horizontal register driving transfer electrodes are formed so as to avoid contacts against the contact regions 9, 9, --- in order to avoid occurrence of short-circuiting.

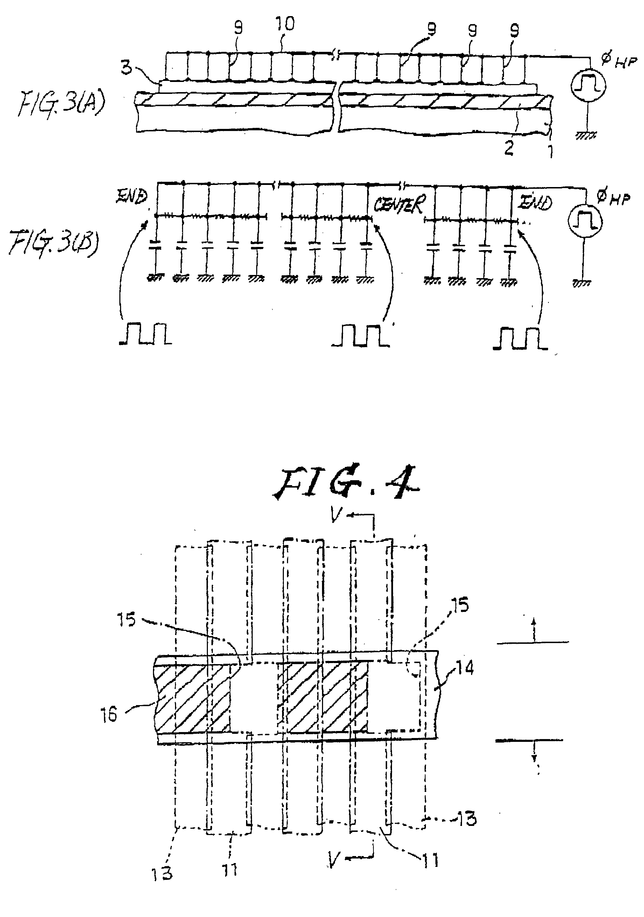

Figs. 3 (A) and 3 (B) show a circuit wiring diagram of the control gate 3 and its equivalent circuit.

Since the metal wiring layer 10, e.g., constituted by aluminium having a sheet resistance extremely lower than the control gate 3 ( one-thousandth or lower) is connected in parallel to one another as a shunt wiring form, a time constant of a transmission path of a gate voltage Ø_{HP} is extremely small. Hence, since the propagation delay can remarkably be reduced, it is possible for the image sensing device to be applied to an HDVS (High Definition Video System).

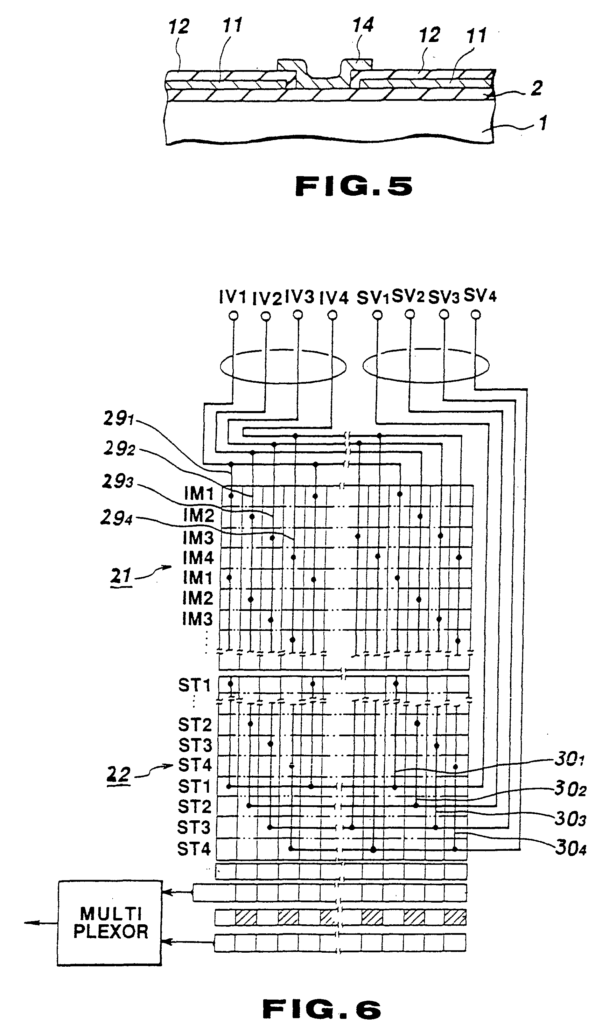

Figs. 4 and 5 show a second preferred additional development to be used with a solid-state frame interline type imager according to the present invention which willl be described below.

In Figs. 4 and 5, numerals 11, 11, 11, --- denote transfer electrodes for driving storage portions of the horizontal registers and constituted by the first polycrystalline silicon layer. Numeral 12 denotes the interlayer insulating film. Numerals 13, 13, --- denote transfer electrodes for driving the transfer portion of the horizontal registers and constituted by the second polycrystalline silicon layer. Numeral 14 denotes the control gate for controlling the signal charge transfer between the horizontal registers, the control gate 14 being placed on an upper portion of the first and second layers of the polycrystalline silicon layers and constituted by polyside. The control gate 14 is opposed to the semiconductor substrate 1 via the insulating layer via regions 15, 15, --- cut out partially along the polycrystalline silicon layers 11, 13, 11, 13. The control gate 14 controls the transfers of signal charges between the two horizontal registers. Channel stops (denoted by oblique lines) 16, 16, 16, --- are arranged between the respective regions 15, 15 controlling the surface of the semiconductor substrate 1.

In the second preferred additional development, since the control gate 14 is constituted by the polyside, the specific resistance along the control gate 14 can be reduced as compared with the conventional one which is merely constituted by the polycrystalline silicon. Hence, the time constant of the signal transmission path through which the gate voltage Ø_{HP} is applied can become small.

It is noted that since the control gate 14 is placed at an upper layer of the transfer electrodes 11, 13 for driving the horizontal registers, the control gate 14 may be formed with the third polycrystalline silicon layer and the metal wiring layer constituted by, e.g., aluminium and which provides a shunt wiring for the upper layer of the control gate 14 may be formed so that the contact regions serve to connect between the metal wiring layer and control gate 14 in order to reduce the specific resistance of the control gate.

Fig. 6 shows a preferred embodiment of the structure of a solid-state frame interline type (FIT) imager according to the present invention.

In the preferred embodiment, a solid-state frame interline type (FIT) image sensing device includes: an image portion having a multinumber of photo receiving elements arranged in the matrix form and a plurality of vertical registers, installed so as to correspond to respective vertical rows of the photo receiving elements, for transferring signal charges stored in the photo receiving elements in the vertical direction; and a storage portion, placed at the vertical transferred portion of the image portion, having a plurality of vertical registers temporarily storing the signal charges generated at the image portion.

Shunt wiring films are formed independently on the transfer electrodes of the vertical registers of the image portion and on the transfer electrodes of the vertical registers of the vertical registers of the storage portion, respectively. The drive pulses are applied to the transfer electrodes corresponding to the shunt wiring films.

The transfer electrodes are controlled by means of a quadruple drive pulse and are constituted by IM1, IM2, IM3, IM4, IM1, IM2, IM3, IM4, ---.

In Fig. 6, numeral 29₁ through 29₄ denote shunt wiring films for the transfer electrodes IM1 through IM4 of the respective vertical registers of the image portion 21 and does not extend toward the storage portion 22. An origin of the shunt wiring films 29₁ through 29₄ is placed on the upper side of the image portion 21. The drive pulses IV1 through IV4 are applied to the respective transfer electrodes IM1 through IM4 of the image portion 21 via the image bus lines sequentially in orders from upper side.

Numerals 30₁ through 30₄ denote shunt wiring films for the respective transfer electrodes ST1 through ST4 of the storage portion 22. The shunt wiring films receive drive pulses SV1 through SV4 for the vertical registers within the storage portion 22 via the bus line from the lower side and transferring the drive pulses via the transfer electrodes ST1 through ST4.

Since, in the preferred embodiment, the shunt wiring films 29₁ through 29₄ of the image portion 1 and those 30₁ through 30₄ are mutually separated so as to operate independently of each other, a coupling capacitance across both image portion 21 and storage portion 22 is substantially reduced by half. Hence, a burden imposed on a clock generator which generates the drive pulses can be reduced, distortions in the drive pulses can be reduced and deteriorations in the operating characteristics in the image sensing device can be prevented.

Although the drive pulses are transmitted to upper portions of the shunt wiring films 29₁ through 29₄ of the image portion 21 and to the lower portions of the shunt wiring films 30₁ through 30₄ of the storage portion 22, the drive pulses may be transmitted to upper and lower end portions of both shunt wiring films 29₁ through 29₄ and shunt wiring films 30₁ through 30₄.

It is noted that a combination of the first or second additional development with the preferred embodiment can be applied to the solid-state image sensing device according to the present invention.

As described above, since in the solid-state image sensing device according to the present invention, the specific resistance of the signal transmission path of the drive pulses can be reduced, the drive pulse signal propagation delays in the solid-state image sensing device can remarkably be reduced and operating characteristics thereof can be improved. Thus, the solid-state image sensing device according to the present invention can be applied to HDVS.

It will fully appreciated by those skilled in the art that the foregoing description has been made in terms of the preferred embodiment and various changes and modifications may be made without departing from the scope of the present invention which is to be defined by the appended claims.

## Claims

1. A solid-state frame interline type (FIT) imager comprising:
(a) an image portion (21) comprising a plurality of photo receiving elements arranged in a matrix form and a plurality of first vertical registers having first transfer electrodes (IM) for transferring in the vertical direction signal charges read out from the plurality of photo receiving elements;
(b) a storage portion (22) comprising a plurality of second vertical registers having second transfer electrodes (ST) for temporarily storing the signal charges transferred from the image portion (21);
(c) a plurality of horizontal registers, each having third transfer electrodes for transferring the signal charges from said storage portion (22) in the horizontal direction sharing the signal charges with respective ones thereof;
(d) first shunt wirings (29) provided over the first transfer electrodes (IM) and connected at selected locations to said first transfer electrodes (IM) said first shunt wirings (29) being used for applying first drive pulses (IV) from a first bus line to the first transfer electrodes (IM); and
(e) second shunt wirings (30) provided separately from said first shunt wirings (29) and provided over the second transfer electrodes (ST) and connected to said second transfer electrodes (ST) at selected locations, said second shunt wirings (30) being used for applying second drive pulses (SV) from a second bus line independent from the first bus line to the second transfer electrodes (ST), said imager further comprising:
a control gate (3, 14) for controlling the transfer of signal charges between said horizontal registers in synchronization with said second drive pulses (SV).

2. An imager as set forth in claim 1, wherein at least one of said shunt wirings comprises a wiring layer (10) connected in parallel to a respective drive pulse transmission path (3) for reducing the specific resistance along said transmission path (3).

3. An imager as set forth in claim 2, wherein the specific resistance reducing means (9, 10) comprises
the control gate (3, 14) formed by a first semiconductor layer located on a semiconductor substrate (1) surface at a first layer portion;
a metal wiring layer (10) connected to the first semiconductor layer via contact regions (9); and
the third transfer electrodes (5, 7) comprised of second and third semiconductor layers located between said metal wiring layer (10) and said first semiconductor layer without contacting said contact regions (9).

4. An imager as set forth in claim 2, wherein the specific resistance reducing means (9, 10) comprises said third transfer electrodes (5, 7) comprised of semiconductor layers having different layers and said control gate (3, 14) formed with the wiring layer (10) placed above said semiconductor layers of said third transfer electrodes (5, 7).

5. An imager as set forth in claim 4, wherein said semiconductor layers of said third transfer electrodes (5, 7) are comprised of first and second layers placed on an upper surface of a semiconductor substrate (1).

6. An imager as set forth in claim 3, wherein said first semiconductor layer is formed of a polycrystalline silicon layer, said first transfer electrodes (5, 7) are formed of polycrystalline silicon layers sandwiched with an interlayer insulating layer (4, 6), and the metal wiring layer (10) is formed of a metal having a sheet resistance much lower than that for the control gate (3, 14).

7. An imager as set forth in claim 6, wherein said metal wiring layer (10) is formed of aluminium.

8. An imager as set forth in claim 4, wherein said third transfer electrodes (5, 7) are formed of a first layer of polycrystalline silicon (11) and of a second layer of polycrystalline silicon (13), the control gate (3, 14) is formed of a polyside (14) placed above said first and second layers of polycrystalline silicon (11, 13) and the control gate (3, 14) opposes a semiconductor substrate (1) at regions where the polycrystalline silicon layers (11, 13) are partially cut out.

9. An imager as set forth in claim 8, wherein a metal wiring layer (10) is formed on a portion above said control gate (3, 14) and contact regions (9) are placed between the metal wiring layer (10) and control gate (3, 14) so as to form a connection therebetween.

10. An imager as set forth in claim 4, wherein said first and second shunt wirings (29; 30) are first and second shunt wiring films (29), respectively.

## Patentansprüche

1. Festkörper-Vollbild-Zwischenzeilen-Abbildeinrichtung (FIT), welche aufweist:
(a) einen Bildbereich (21), der aus mehreren Fotoempfangselementen, die matrixartig angeordnet sind, und mehreren ersten Vertikalregistern besteht, welche erste Übertragungselektroden (IM) haben, um Ladungen, die von den mehreren Fotoempfangselementen gelesen werden, in der Vertikalrichtung zu übertragen;
(b) einen Speicherbereich (22), der mehrere zweite Vertikalregister aufweist, welche zweite Übertragungselektroden (ST) haben, um die Signalladungen, die vom Abbildbereich (21) übertragen werden, vorübergehend zu speichern;
(c) mehrere Horizontalregister, die jeweils dritte Übertragungselektroden haben, um die Signalladungen vom Speicherbereich (22) in der Horizontalrichtung zu übertragen, die die Signalladungen mit ihren entsprechenden anteilig nutzen;
(d) erste Nebenschlussverdrahtungen (29), die über den ersten Übertragungselektroden (IM) vorgesehen sind und die an ausgewählten Stellen mit den ersten Übertragungselektroden (IM) verbunden sind, wobei die ersten Nebenschlussverdrahtungen (29) dazu verwendet werden, erste Ansteuerungsimpulse (IV) von einer ersten Busleitung an die ersten Übertragungselektroden (IM) anzulegen; und
(e) zweite Nebenschlussverdrahtungen (30), die separat von den ersten Nebenschlussverdrahtungen (29) vorgesehen sind und die über den zweiten Übertragungselektroden (ST) vorgesehen sind und mit den zweiten Übertragungselektroden (ST) an ausgewählten Stellen verbunden sind, wobei die zweiten Nebenschlussverdrahtungen (30) dazu verwendet werden, zweite Ansteuerungsimpulse (SV) von einer zweiten Busleitung unabhängig von der ersten Busleitung an die zweite Übertragungselektroden (ST) anzulegen, wobei die Abbildeinrichtung außerdem aufweist:
ein Steuerungsgate (3, 14), um die Übertragung von Signalladungen zwischen den Horizontalregistern synchron mit den zweiten Ansteuerungsimpulsen (SV) zu steuern.

2. Abbildeinrichtung nach Anspruch 1, wobei zumindest eine der Nebenschlussverdrahtungen eine Verdrahtungsschicht (10) aufweist, welche parallel mit einem entsprechenden Ansteuerimpuls-Übertragungspfad (3) verbunden ist, um den spezifischen Widerstand längs des Übertragungspfads (3) zu reduzieren.

3. Abbildeinrichtung nach Anspruch 2, wobei die Reduziereinrichtung (9, 10) für den spezifischen Widerstand aufweist:
das Steuerungsgate (3, 14), welches durch eine erste Halbleiterschicht gebildet ist, die auf einer Fläche eines Halbleitersubstrats (1) bei einem ersten Schichtbereich angeordnet ist;
eine Metallverdrahtungsschicht (10), welche mit der ersten Halbleiterschicht über Kontaktbereiche (9) verbunden ist; und
die dritten Übertragungselektroden (5, 7), welche aus den zweiten und den dritten Halbleiterschichten bestehen, welche zwischen der Metallverdrahtungsschicht (10) und der ersten Halbleiterschicht angeordnet sind, ohne die Kontaktbereiche (9) zu kontaktieren.

4. Abbildeinrichtung nach Anspruch 2, wobei die Reduziereinrichtung (9, 10) für den spezifischen Widerstand die dritten Übertragungselektroden (5, 7), die aus Halbleiterschichten bestehen, die unterschiedliche Schichten haben, und das Steuerungsgate (3, 14) aufweist, welches mit der Verdrahtungsschicht (10) gebildet ist, die über den Halbleiterschichten der dritten Übertragungselektroden (5, 7) angeordnet ist.

5. Abbildeinrichtung nach Anspruch 4, wobei die Halbleiterschichten der dritten Übertragungselektroden (5, 7) aus ersten und zweiten Schichten bestehen, die auf einer oberen Fläche des Haltleitersubstrats (1) angeordnet sind.

6. Abbildeinrichtung nach Anspruch 3, wobei die erste Halbleiterschicht aus einer polykristallinen Siliziumschicht gebildet ist, die ersten Übertragungselektroden (5, 7) aus polykristallinen Siliziumschichten gebildet sind, zwischen welcher einer Zwischenschicht-Isolationsschicht (4, 6) angeordnet ist, und die Metallverdrahtungsschicht (10) aus einem Metall gebildet ist, welches einen Schichtwiderstand hat, der wesentlich niedriger ist als der für das Steuerungsgate (3, 14).

7. Abbildeinrichtung nach Anspruch 6, wobei die Metallverdrahtungsschicht (10) aus Aluminium gebildet ist.

8. Abbildeinrichtung nach Anspruch 4, wobei die dritten Übertragungselektroden (5, 7) aus einer ersten Schicht aus polykristallinem Silizium (11) und aus einer zweiten Schicht aus polykristallinem Silizium (13) gebildet sind, das Steuerungsgate (3, 14) aus einem Polysid gebildet ist, welches über der ersten und der zweiten Schicht des polykristallinem Siliziums (11, 13) angeordnet ist und das Steuerungsgate (3, 14) einem Halbleitersubstrat (1) an den Bereichen gegenüberliegt, wo die polykristallinen Siliziumschichten (11, 13) teilweise ausgeschnitten sind.

9. Abbildeinrichtung nach Anspruch 8, wobei eine Metallverdrahtungsschicht (10) auf einem Bereich über dem Steuerungsgate (3, 14) gebildet ist und Kontaktbereiche (9) zwischen der Metallverdrahtungsschicht (10) und dem Steuerungsgate (3, 14) angeordnet sind, um eine Verbindung dazwischen zu bilden.

10. Abbildeinrichtung nach Anspruch 4, wobei die erste und die zweite Nebenschlussverdrahtung (29; 30) erste bzw. zweite Nebenschlussverdrahtungsschichten (29) sind.

## Revendications

1. Imageur du type à interligne de trame (FIT) à l'état solide comprenant :
(a) une partie d'image (21) comprenant une pluralité d'éléments de réception photo disposés sous forme de matrice et une pluralité de registres verticaux ayant des premières électrodes de transfert (IM) pour transférer dans la direction verticale des charges de signal extraites de la pluralité d'éléments de réception photo ;
(b) une partie de stockage (22) comprenant une pluralité de seconds registres verticaux ayant des secondes électrodes de transfert (ST) pour stocker temporairement les charges de signal transférées à partir de la partie d'image (21) ;
(c) une pluralité de registres horizontaux, ayant chacun des troisièmes électrodes de transfert pour transférer les charges de signal à partir de ladite partie de stockage (22) dans la direction horizontale partageant les charges de signal par rapport à celle de celles-ci ;
(d) premiers câblages de shunt (29) placés sur les premières électrodes de transfert (IM) et raccordés à des emplacements sélectionnés auxdites premières électrodes de transfert (IM) lesdits premiers câblages de shunt (29) étant utilisés pour appliquer des premières impulsions de commande (IV) à partir d'une première ligne de bus jusqu'aux premières électrodes de transfert (IM) ; et
(e) des seconds câblages de shunt (30) sont placés séparément desdits premiers câblages de shunt (29) et placés sur les secondes électrodes de transfert (ST) et raccordés auxdites secondes électrodes de transfert (ST) à des emplacements sélectionnés, lesdits seconds câblages de shunt (30) étant utilisés pour appliquer des secondes impulsions de commande (SV) à partir d'une seconde ligne de bus indépendamment de la première ligne de bus jusqu'aux secondes électrodes de transfert (ST), ledit imageur comprenant en outre :
une grille de commande (3, 14) pour commander le transfert de charges de signal entre lesdits registres horizontaux en synchronisme avec lesdites secondes impulsions de commande (SV).

2. Imageur selon la revendication 1, dans lequel au moins un desdits câblages de shunt comprend une couche de câblage (10) montée parallèlement à un chemin de transmission d'impulsions de commande respectif (3) pour réduire la résistance spécifique le long dudit chemin de transmission (3).

3. Imageur selon la revendication 2, dans lequel le moyen de réduction de résistance spécifique (9, 10) comprend :
la grille de commande (3, 14) formée par une première couche semi-conductrice située sur une surface de substrat semi-conducteur (1) sur une première partie de couche ;
une couche de câblage de métal (10) raccordée à la première couche semi-conductrice via des zones de contact (9) ; et
les troisièmes électrodes de transfert (5, 7) composées des seconde et troisième couches semi-conductrices situées entre ladite couche de câblage de métal (10) et ladite première couche semi-conductrice sans contacter lesdites zones de contact (9).

4. Imageur selon la revendication 2, dans lequel un moyen de réduction de résistance spécifique (9, 10) comprend lesdites troisièmes électrodes de transfert (5, 7) composées des couches semi-conductrices ayant différentes couches et ladite grille de commande (3, 14) formée avec les couches de câblage (10) placées au-dessus desdites couches semi-conductrices desdites troisièmes électrodes de transfert (5, 7).

5. Imageur selon la revendication 4, dans lequel lesdites couches semi-conductrices desdites troisièmes électrodes de transfert (5, 7) sont composées des première et seconde couches placées sur une surface supérieure d'un substrat semi-conducteur (1).

6. Imageur selon la revendication 3, dans lequel ladite première couche semi-conductrice est formée d'une couche de silicium polycristallin, lesdites trois premières électrodes de transfert (5, 7) sont formées de couches de silicium polycristallin intercalées avec une couche d'isolation intercouche (4, 6) et la couche de câblage de métal (10) est formée d'un métal ayant une résistance de feuille beaucoup plus petite que celle pour la grille de commande (3, 14).

7. Imageur selon la revendication 6, dans lequel ladite couche de câblage de métal (10) est formée d'aluminium.

8. Imageur selon la revendication 4, dans lequel lesdites troisièmes électrodes de transfert (5, 7) sont formées d'une première couche de silicium polycristallin (11) et d'une seconde couche de silicium polycristallin (13), la grille de commande (3, 14) est formée de silicium polycristallin (14) placée au-dessus desdites première et seconde couches de silicium polycristallin (11, 13) et les grilles de commande (3, 14) sont opposées à un substrat semi-conducteur (1) sur des zones où les couches de silicium polycristallin (11, 13) sont partiellement découpées.

9. Imageur selon la revendication 8, dans lequel la couche de câblage de métal (10) est formée d'une partie au-dessus de la grille de commande (3, 14) et des zones de contact (9) sont placées entre la couche de câblage de métal (10) et la grille de commande (3, 14) afin de former une connexion entre eux.

10. Imageur selon la revendication 4, dans lequel les premier et second câblages de shunt (29, 30) sont des premier et second films de câblage de shunt (29), respectivement.
